# EUROPEAN PATENT SPECIFICATION

(11) **EP 0 460 966 B1**
(45) Date of publication and mention of the grant of the patent: **08.09.1999**
(21) Application number: 91305161.1
(22) Date of filing: 07.06.1991
(51) Int. Cl.: C23C 14/08, C23C 14/02, B32B 27/08, B65D 65/38, B32B 27/02

(54) **Barrier film having high colorless transparency and method of manufacture thereof**
Sperrfilm mit hoher farbloser Transparenz und Verfahren zu dessen Herstellung
Film-barrière ayant une haute transparence incolore et méthode pour le fabriquer

(30) Priority: 08.06.1990 US 535183
(43) Date of publication of application: 11.12.1991
(73) Proprietor: FLEX PRODUCTS, INC., Santa Rosa California 95407 (US)
(72) Inventor: Phillips, Roger W., Santa Rosa, California 95405 (US); Wendt, Lauren R., Santa Rosa, California 95403 (US); Tan-Johnson, Myra, Petaluma, California 94975 (US); Todd, David W., Sebastopol, California 95472 (US)
(74) Representative: Bayliss, Geoffrey Cyril

(56) References cited:
- EP-A- 0 240 571
- GB-A- 2 210 826
- US-A- 3 442 686
- DATABASE WPI Section Ch, Week 8930, 1989 Derwent Publications Ltd., London, GB; Class A11, AN 89-215699 & JP-A-1 152 054 (TORAY IND INC) 14 June 1989
- DATABASE WPI Section Ch, Week 8744, 1987 Derwent Publications Ltd., London, GB; Class A08, AN 87-311068 & JP-A-62 220 330 (TORAY IND INC) 28 September 1987
- DATABASE WPI Section Ch, Week 8850, 1988 Derwent Publications Ltd., London, GB; Class A09, AN 88-356265 & JP-A-63 265 626 (TORAY IND INC) & PATENT ABSTRACTS OF JAPAN vol. 13, no. 60 (M-796) 10 February 1989 & JP-A-63 265 626 (TORAY IND INC) 2 November 1988
- DATABASE WPI Section Ch, Week 8949, 1989 Derwent Publications Ltd., London, GB; Class A09, AN 89-360325 & JP-A-1 269 530 (TOPPAN PRINTING K.K.) 27 October 1989
- DATABASE WPI Section Ch, Week 9037, 1990 Derwent Publications Ltd., London, GB; Class A09, AN 90-278515 & JP-A-2 194 944 (TOPPAN PRINTING K.K.) 1 August 1990 & PATENT ABSTRACTS OF JAPAN vol. 14, no. 481 (M-1037) 19 October 1990 & JP-A-02 194 944 (TOPPAN PRINTING CO.LTD.) 1 August 1990
- PATENT ABSTRACTS OF JAPAN vol. 15, no. 133 (C-0820) 2 April 1991 & JP-A-03 017 252 (TOPPAN PRINTING CO. LTD.) 25 January 1991
- PATENT ABSTRACTS OF JAPAN vol. 15, no. 216 (C-0837) 4 June 1991 & JP-A-03 064 449 (REIKO CO. LTD.) 19 March 1991
- PATENT ABSTRACTS OF JAPAN vol. 14, no. 58 (M-930) 2 February 1990 & JP-A-01 283 135 (MITSUBISHI MONSANTO CHEM CO.) 14 November 1989

## Description

This invention relates to a barrier film having high colorless transparency and a method for forming the same.

Barrier films have heretofore been provided. Typical coatings are of the type disclosed in British patent specification 1,086,482 corresponding to US-A-3 442 686. It is disclosed therein that the preferred inorganic coatings are oxides of silicon and aluminum which can be deposited as transparent flexible coatings in a glassy state. Silicon monoxide or silicon dioxide are mentioned as starting materials and aluminum oxide for the aluminum coatings. This aluminum oxide is identified in Table V as being Norton Alundum #4186. This is not a pure aluminum oxide but a mixture of aluminum oxide and silicon dioxide (Al₂O₃ in a SiO₂ binder). Zirconium oxide is also mentioned as a starting material. However, this material is not particularly suited for evaporation techniques because of its high melting temperature. Silver chloride which is also identified as a starting material is undesirable because it becomes hazy when deposited as a coating material. With respect to all of the starting materials mentioned, they are deposited as a single layer. In coating operations, the roll speed is very slow at the rate of 3 inches per minute. The single layer is also deposited to a thickness, as for example, 6000 x 10⁻¹⁰m (6000 Angstroms) which is very thick. It is pointed out that the minimum thickness is 200 x 10⁻¹⁰m (0.02 microns [200A]). Below this thickness the inorganic barrier layer is ineffectual. The tables in the British patent specification 1,086,482 disclose the barrier properties with respect to oxygen and helium, but do not address water permeabillty. In addition, in U.S. Patent No. 4,702,963 there is disclosed a barrier film which is made from silicon monoxide or a suboxide of SiO₂. Although this barrier film has good barrier properties, it has the undesirable feature that it has an amber color. This amber color is objectionable in many packaging applications because it obscures the true color of the product within the package. It has been found that when silicon dioxide is deposited directly on a film by electron beam evaporation no additional barrier properties are provided by the silicon dioxide. In European Patent Application No. 0240571 there is disclosed the application of silicon dioxide and aluminum oxide on a heat resistant microwave transparent polymer film such as polypropylene or polyester. In Table 1 there is disclosed an SiO₂ layer thicknesses between 50 and 100 nm on a 25 percent polyester film.

There is therefore a need for a new and improved barrier film which has a colorless transparency. In addition, there is a need to replace existing aluminized polyester and co-extruded polymeric films. Also, in view of solid waste disposal problems, there is a need to limit the use of non-recyclable plastic films. There is also a need to reduce the total volume of plastic waste which is non-recyclable by reducing the thickness and the number of plastic layers and by recycling the plastic film. Co-extruded plastic film structures are not easily recycled because of the complexity of the chemical structures in the co-extrudants. There is also a need to reduce the use of PVC and PVDC as barrier materials in film in order to eliminate migration of unreacted monomers reaching food contents packaged within such barrier films.

In general, it is an object of the present invention to provide a barrier film having high colorless transparency and a method for making the same.

Another object of the invention is to provide a barrier film of the above character which will tear in a straight line.

Another object of the invention is to provide a barrier film of the above character which does not require the use of aluminum.

Another object of the invention is to provide a barrier film of the above character which does not require the use of co-extruded polymeric films.

Another object of the invention is to provide a barrier film of the above character which reduces the total volume of plastic required.

Another object of the invention is to provide a barrier film of the above character which reduces the difficulty of recycling.

Another object of the invention is to provide a barrier film of the above character which can be utilized for food packaging which can be used in microwave ovens.

Another object of the invention is to provide a barrier film of the above character which uses a non-metal which can be utilized for packaging food which can be used in a microwave unit and still be transparent with a long shelf life.

Another object of the invention is to provide a barrier film of the above character in which PVDC need not be utilized as barrier materials.

Another object of the invention is to provide a barrier film of the above character which can maintain a given moisture content for contents packaged in the barrier film.

Another object of the invention is to provide a barrier film and method in which the barrier film can be produced in a roll coater at high production speeds.

Another object of the invention is to provide a barrier film of the above character which is provided with a heat seal layer so that it can be readily utilized as a self-sealing packaging material.

Additional objects and features of the invention will appear from the following description in which the preferred embodiments are set forth in detail in conjunction with the accompanying drawings.

Figure 1 is a cross sectional view of a barrier film incorporating the present invention in which a barrier layer is provided on one side of the flexible plastic substrate.

Figure 2 is a cross sectional view of a barrier film incorporating the present invention in which a barrier layer is provided on both sides of the flexible plastic substrate.

Figure 3 is a cross sectional view similar to the one shown in Figure 1 with a heat seal layer to facilitate use of the barrier film as a packaging material.

Figure 4 is a cross sectional view similar to Figure 3 but showing the use of heat seal layers on both sides of the substrate to facilitate use of the barrier film in packaging materials.

Figure 5 is a cross sectional view of a barrier film in which the barrier is provided by a single layer.

Figure 6 is a graph showing water vapor transmission data using aluminum oxide and silicon dioxide layers.

Figure 7 is a graph showing water vapor transmission data for tin oxide and silicon dioxide layers.

Figure 8 is a graph showing water vapor transmission data using yttrium oxide and silicon dioxide layers.

Figures 9 and 10 are cross-sectional views showing two pre-lamination constructions incorporating the present invention for a packaging film.

Figure 11 is a cross-sectional view showing the packaging film post-lamination.

Figure 12 is a cross-sectional view of a heat seal coated packaging film.

Figure 13 is a cross-sectional view of a barrier-type film construction which is heat sealable onto itself and on which the two layers of a barrier coating are provided facing each other.

Figure 14 is a graph showing water vapor transmission rates for single layer aluminum oxide (AL₂O₃) on 70 gauge polypropylene.

In general, the barrier film having a high colorless transparency is comprised of a substrate formed essentially of a plastic having first and second surfaces. A barrier layer is formed on the first surface and has a thickness ranging from approximately 50 x 10⁻¹⁰m to 180 x 10⁻¹⁰m (50 to 180 Angstroms) and is formed from a material selected from the group of aluminum oxide (Al₂O₃) and yttrium oxide (Y₂O₃).
An additional layer of silicon dioxide may be formed on the barrier layer and having a thickness ranging from 100 x 10⁻¹⁰m to 1000 x 10⁻¹⁰m (100 to 1000) Angstroms.

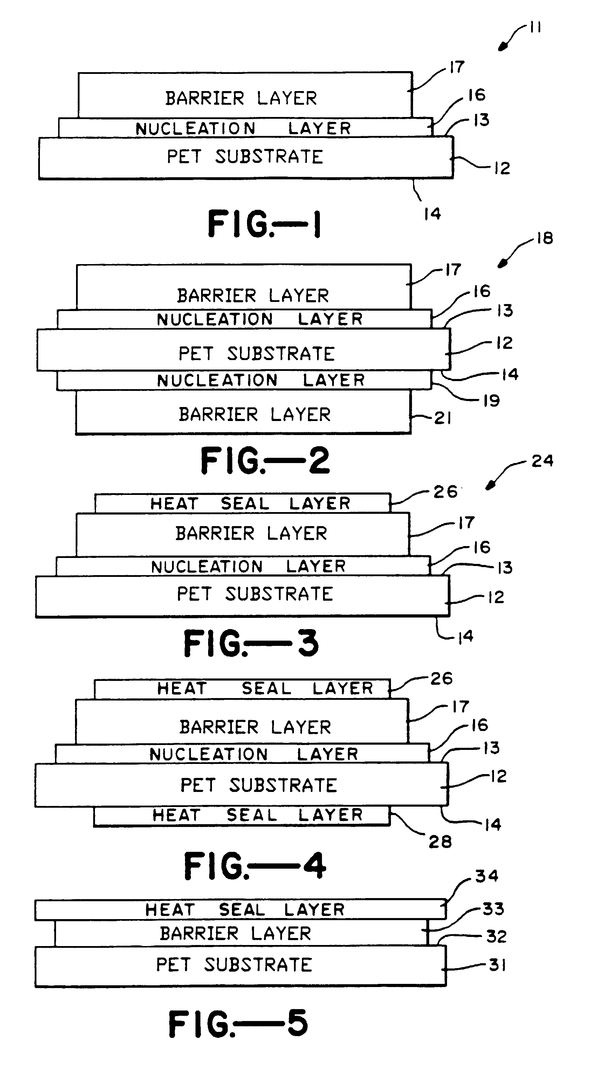

More in particular, as shown in Figure 1, the barrier film 11 is comprised of a substrate 12 formed of a suitable flexible plastic as, for example, PET which is a polyester having a thickness ranging from approximately 48 gauge which is approximately 1.2 x 10⁻⁵m (0.5 mil) to a thickness of 10.2 x 10⁻⁵ (4 mils). The substrate is provided with first and second surfaces 13 and 14. A nucleation layer 16 of a thickness ranging from approximately 50 x 10⁻¹⁰m to 100 x 10⁻¹⁰m (50 to 100 Angstroms) is deposited on the surface 13. The nucleation layer is formed of a single material selected from pure aluminum oxide (Al₂O₃), pure yttrium oxide (Y₂O₃), with pure meaning 99.0% purity or better. Typically the nucleation layer is formed by electron beam evaporation of material onto the surface 13. If desired, the material also can be deposited by sputtering. Electron beam evaporation has been found to be desirable because it is possible to evaporate material rapidly and over a wide area so that the material can be applied cost effectively on rapidly moving sheet material in a roll coater. By way of example, the material forming the nucleation layer can be evaporated over a width of at least two meters and with a rapidly moving film.

A barrier layer 17 formed of silicon dioxide (SiO₂) is then deposited upon the nucleation layer 16. The starting material is silicon dioxide which is a clear transparent material. It is deposited by electron beam evaporation to a thickness ranging from 100 x 10⁻¹⁰m to 1000 x 10⁻¹⁰m (100 to 1000 Angstroms). Alternatively, if desired, the silicon dioxide can then be deposited by reactive sputtering. As hereinafter pointed out that MS-65 produced by Flex Products, Inc. of Santa Rosa, California can be substituted for the silicon dioxide.

The coating applied to the surface 13 which is comprised of the nucleation layer 16 and the barrier layer 17 is deposited in a two-step process in which the nucleation layer 16 is deposited first followed by the silicon dioxide barrier layer 17. This can be readily accomplished on a roll coater by first depositing the nucleation layer 16 followed by the silicon dioxide layer 17 at subsequent spaced apart locations in the roll coater. Alternatively, the two layers, the nucleation layer and the barrier layer 17 can be deposited in two separate passes of the film in the roll coater.

If still further improved barrier properties are desired for the film, the same type of coating which is placed on the one side or surface 13 of the flexible plastic substrate 12 can also be placed on the other side or surface 14 of the substrate 12. Thus, there has been provided in Figure 2, a barrier film 18 which has the nucleation layer 16 and the barrier layer 17 on the surface 13 and an additional nucleation layer 19 on the surface 14 followed by a silicon dioxide barrier layer 21. The two layers 19 and 21 can be formed of the same materials and can have the same characteristics as the layers 16 and 17 on the surface 13 of the substrate 12.

When the barrier film of the present invention is to be utilized as a packaging material, a barrier film 24 of the type shown in Figure 3 can be utilized. The embodiment of the barrier film 11 shown in Figure 1 is provided with a heat seal layer 26 formed of a suitable heat sealing material well known to those skilled in the art. A suitable heat sealing material would be cross-linked ethylene acrylic acid or high molecular weight ethylene acetate polymers or urethane polymers. Typically this could be accomplished by taking the roll coated polyester which has been coated with the nucleation layer 16 and the barrier layer and depositing the heat seal layer using a gravure coater or slot coater or other appropriate coater. The heat sealing material typically would be of a material in which heat sealing could be accomplished at 100 to 150°C with a few seconds of contact.

When heat seal capabilities are desired on both sides of a barrier film, a barrier film 27 such as that shown in Figure 4 can be utilized in which another heat seal layer 28 is provided on the surface 14. This heat seal layer 28 can be formed of the same material as the heat seal layer 26. The heat seal layers can have a typical thickness ranging from 0.25 x 10⁻⁵m to 2.5 x 10⁻⁵m (0.1 - 1 mil).

Table 1 as set forth below which sets forth water vapor barrier film data for barrier films, on polyester terephthalate PET) which has been collected in making barrier films in accordance with the present invention. Those films which include silicon dioxide (SiO₂) only or tin oxide (SnO₂) are included as comparative examples only.

**TABLE 1**

| **WATER VAPOR BARRIER FILM DATA** | | |
|---|---|---|
| | **BOX COATER** | |
| **Design Thickness** | **Subtrate** | **WVTR g/100 sq.in/day** |
| UNCOATED | 1 mil PET | 1.2 - 1.3 |
| UNCOATED | 2 mil PET | .56 - .63 |
| | | |
| 2000Å SiO₂ | 2 mil PET | 0.51 |
| 1000Å SiO₂ | 2 mil PET | 0.67 |
| 500Å SiO₂ | 2 mil PET | 0.67 |
| | | |
| 100Å Al₂O₃/500Å SiO₂ | 1 mil PET | 0.072 |
| 50Å Al₂O₃/500Å SiO₂ | 1 mil PET | 0.063 |
| 25Å Al₂O₃/500Å SiO₂ | 1 mil PET | 0.419 |
| 10Å Al₂O₃/500Å SiO₂ | 1 mil PET | 1.39 |
| | | |
| 100Å Al₂O₃/500Å SiO₂ | 2 mil PET | 0.072 |
| 50Å Al₂O₃/500Å SiO₂ | 2 mil PET | 0.064 |
| 25Å Al₂O₃/500Å SiO₂ | 2 mil PET | 0.159 |
| 10Å Al₂O₃/500Å SiO₂ | 2 mil PET | 0.68 |
| | | |
| 100Å Al₂O₂/250Å SiO₂ | 1 mil PET | 0.111 |
| 50Å Al₂O₃/250Å SiO₂ | 1 mil PET | 0.122 |
| 25Å Al₂O₃/250Å SiO₂ | 1 mil PET | 0.14 |
| 10Å Al₂O₃/250Å SiO₂ | 1 mil PET | 1.45 |
| | | |
| 100Å Al₂O₃/250Å SiO₂ | 2 mil PET | 0.104 |
| 50Å Al₂O₃/250Å SiO₂ | 2 mil PET | 0.092 |
| 25Å Al₂O₃/250Å SiO₂ | 2 mil PET | 0.629 |
| 10Å Al₂O₂/250Å SiO₂ | 2 mil PET | 0.69 |
| | | |
| 100Å SnO₂/500Å SiO₂ | 1 mil PET | 0.058 |
| 50Å SnO₂/500Å SiO₂ | 1 mil PET | 0.073 |
| 25Å SnO₂/500Å SiO₂ | 1 mil PET | 0.589 |
| | | |
| 100Å SnO₂/500Å SiO₂ | 2 mil PET | 0.073 |
| 50Å SnO₂/500Å SiO₂ | 2 mil PET | 0.079 |
| 25Å SnO₂/500Å SiO₂ | 2 mil PET | 0.364 |
| | | |
| 100Å Y₂O₃/500Å SiO₂ | 2 mil PET | 0.0468 |
| 50Å Y₂O₃/500Å SiO₂ | 2 mil PET | 0.0747 |
| 25Å Y₂O₃/500Å SiO₂ | 2 mil PET | 0.26 |
| | | |
| 100Å Y₂O₃/500Å SiO₂ | 1 mil PET | 0.035 |
| 50Å Y₂O₃/500Å SiO₂ | 1 mil PET | 0.0917 |
| 25Å Y₂O₃/500Å SiO₂ | 1 mil PET | 0.542 |
| NB 1 Ångström = 1 x 10⁻¹⁰m 1 mil = 2.54 x 10⁻⁵m 1g/100 sq. in./day = 1g/6.45 x 10⁻²m²/day | | |

| | ROLL COATER | |
|---|---|---|
| Design Thickness | Substrate | WVTR |
| | | g/100 sq.in./day |
| 75Å Al₂O₃/250Å SiO₂ | 1 mil PET | 0.14 |
| 75Å Al₂O₃/375Å SiO₂ | 1 mil PET | 0.13 |
| 75Å Al₂O₃/500Å SiO₂ | 1 mil PET | 0.14 |

It can be seen that the data in the above-identified table is gathered from two sources; a box coater and a roll coater. The water vapor transmission rate is set forth in grams per 100 square inches per day of barrier film. The flexible plastic substrate utilized had a thickness of 2.54 x 10⁻⁵m and 5.08 x 10⁻⁵m (1 and 2 mils) as shown. The table shows when the substrate was uncoated it had a water transmission rate that is directly related to the thickness of the film. Coating of the substrate with silicon dioxide alone at various thicknesses did very little, if any, to increase the barrier properties of the film. However, the addition of a nucleation layer formed of one of the materials previously identified gave dramatic improvements in the reduction in water vapor transmission rate as shown in the above table by a factor of approximately 20. It also shows that the water vapor transmission rate was not changed significantly by increasing the thickness of the substrate.

Certain other data shown in Table 1 has been plotted in the graphs shown in Figures 6, 7 and 8. The data for the aluminum oxide nucleation layer is plotted in Figure 6, whereas the data for the tin oxide nucleation layer is plotted in Figure 7. Four plots are shown in Figure 6. From Figure 6, it can be seen that three variables are being plotted, the water vapor transmission rate, the Angstroms of aluminum oxide and the thickness of the silicon dioxide barrier layer. The graph shows that the thicker layers of silicon dioxide are more effective as a barrier to water vapor transmission than the thinner layer.

In examining the chart in Figure 6, it also can be seen that when the nucleation layer of aluminum oxide becomes less than 50 x 10⁻¹⁰m (50 Angstroms), the water vapour transmission rate rises very sharply so that the combination of the aluminum oxide nucleation layer and the silicon dioxide layer is relatively ineffective as a water vapor barrier. Thus it can be seen that the basic parameter which controls the large variation in water vapor transmission rate is the thickness of the aluminum oxide nucleation layer. There is a minor change due to the thickness of the silicon dioxide layer.

In comparing the results in box coaters with roll coaters as shown in Table 1, it can be seen that the results obtained in the roll coater show that the water vapor transmission rate is not quite as low in the roll coater as in the box coater. This is believed to be due to the fact that there are more variables in a roll coater making it more difficult to achieve the same results as in a box coater. However, it can be seen that the results are substantially equivalent and that the great advantage in using the roll coater in producing barrier films at high capacity can make the use of roll coaters for forming such barrier films very desirable because of the cost effectiveness of the roll coaters.

From examining the data which is shown in Table 1, it can be seen that improvements by a factor of 20 can be obtained in the water vapor transmission rate with the use of the nucleation layer and the silicon dioxide layer of the type hereinbefore described. In addition, it can be seen that the water vapor transmission rate is relatively independent of the thickness of the substrate indicating that the barrier qualities are principally provided by the coating on the substrate.

Of the materials utilized for a nucleation layer, the aluminum oxide and the yttrium oxide, both provide barrier films which are water white transparent.

By way of a comparative example, if tin oxide is utilized as a nucleation layer with silicon dioxide as shown in the graph in Figure 7, results similar to that non in Figure 6 are obtained. Again, it can be seen that when the nucleation layer has a thickness of less than 50 x 10⁻¹⁰m (50 Angstroms), the water vapour transmission rate rises sharply so that it is apparent that whenever the nucleation layer is less than 50 Angstroms in thickness, the water vapor barrier capabilities rapidly diminish. It also can be seen that the thickness of the substrate has very little effect on the water vapor transmission characteristics, although, it is noted that a slightly improved vapor transmission rate is achieved with the thicker substrate.

When yttrium oxide is used as the nucleation layer with silicon dioxide as shown in the graph in Figure 8 results similar to that obtained in Figures 6 and 7 are obtained. These graphs in Figures 6, 7 and 8 show that with all four designs with 1 and 2 mil PET, the nucleation layer has an effect at 50 x 10⁻¹⁰m (50 Angstroms) and above in thickness.

It has been noted that sometimes when the heat seal coatings are applied, the WVTR's are reduced even further. This effect is attributed to the heat seal coating filling up microscopic pores or pin holes in the oxide coating. This is demonstrated by Table 2 set forth below which gives water vapor transmission rates of barrier films of the present invention.

**TABLE 2**

| **WATER VAPOUR TRANSMISSION RATES (WVTR) WVTR of Heat Sealed 2.54 x 10**^{**-5**}**m (1 mil)** **ICI 393/Al**_{**2**}**O**_{**3**} **75 x 10**^{**-10**}**m (75 Å)/SiO**_{**2**} **250Å*** | |
|---|---|
| Oxide Barrier | 0.33 ± 0.026 |
| Heat Seal/Oxide Barrier | 0.135 ± 0.034 |

| | |
|---|---|
| *Heat seal thickness = 0.38 x 10⁻⁵m (0.15 mil) | |

An oxygen permeation test on the 2.54 x 10⁻⁵m (1 mil) of roll coated material is set forth below in Table 3:

**TABLE 3**

| **OXYGEN TRANSMISSION** | |
|---|---|
| Design Thickness | O₂ TR |
| | |
| 75 x 10⁻¹⁰m (75Å) Al₂O₃ | 0.15 x 10⁻⁶m³/6.45 x 10⁻²m²/day |
| 500 x 10⁻¹⁰m (500Å) SiO₂ | (0.15 cc/100 sq. in./day) |
| | |
| 100 x 10⁻¹⁰m (100Å) Y₂O₃ | 0.0645 x 10⁻⁶m³/6.45 x 10⁻²m²/day |
| 500 x 10⁻¹⁰m(500Å) SiO₂ | (0.0645 cc/100 sq. in./day) |
| | |
| uncoated substrate | 3-4 x 10⁻⁶m³/6.45 x 10⁻²m²/day (3-4 cc/100 sq. in./day) |

In accordance with the present invention, it has been found that single layers of very thin Al₂O₃ or Y₂O₃ in the range of 75 x 10⁻¹⁰m to 175 x 10⁻¹⁰m (75Å to 175Å) give extremely good barriers toward water vapour as set forth in Tables 4 and 5 below. In the tables, examples comprising tin oxide (SnO₂) are included as comparative examples only.

**TABLE 4**

| **WATER VAPOR DATA** | | |
|---|---|---|
| | **BOX COATER** | |
| **Design Thickness** | **Substrate** | **WVTR** |
| (1 Angstrom = 1 x 10⁻¹⁰m) | (1 mil = 2.54 x 10⁻⁵m) | g/6.45 x 10⁻²m²/day (g/100 sq.in./day) |
| Uncoated | 1 mil PET | 1.2-1.3 |
| Uncoated | 2 mil PET | .56-.63 |
| | | |
| 100Å SnO₂ | 1 mil PET | 1.06 |
| 100Å SnO₂ | 2 mil PET | 0.56 |
| | | |
| 100Å Y₂O₃ | 1 mil PET | 0.08 |
| 100Å Y₂O₃ | 2 mil PET | 0.086 |
| | | |
| 100Å Al₂O₃ | 1 mil PET | 0.08 |
| 100Å Al₂O₃ | 2 mil PET | 0.091 |
| | | |
| 100Å MS65 | 1 mil PET | 0.0461 |
| 100Å MS65 | 2 mil PET | 0.051 |
| | | |
| 100Å SnO₂/500Å SiO₂ | 1 mil PET | 0.073 |
| 100Å SnO₂/500Å SiO₂ | 2 mil PET | 0.079 |
| | | |
| 100Å Y₂O₃/500Å SiO₂ | 1 mil PET | 0.033 |
| 100Å Y₂O₃/500Å SiO₂ | 2 mil PET | 0.075 |
| | | |
| 100Å Al₂O₃/500Å SiO₂ | 1 mil PET | 0.072 |
| 100Å Al₂O₃/500Å SiO₂ | 2 mil PET | 0.075 |
| | | |
| 100Å MS65/500Å SiO₂ | 1 mil PET | 0.25 |
| 100Å MS65/500Å SiO₂ | 2 mil PET | 0.18 |
| | | |
| 100Å Al₂0₃/500Å MS65 | 1 mil PET | 0.0375 |
| 100Å Al₂O₃/500Å MS65 | 2 mil PET | 0.05 |

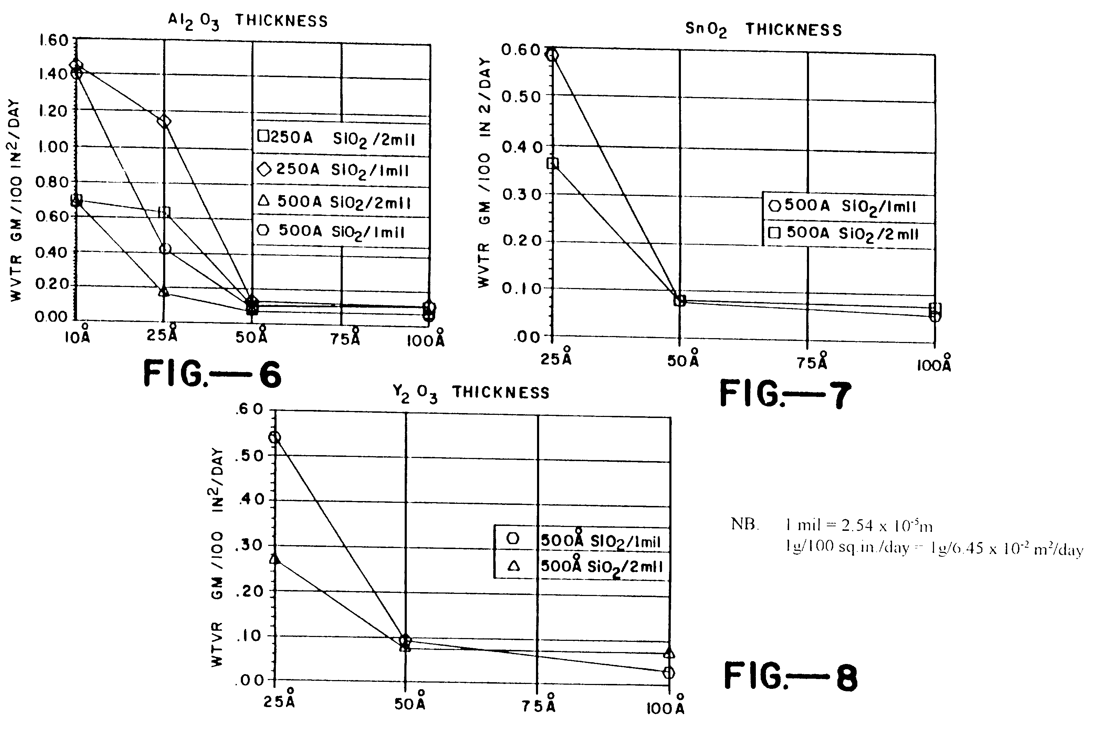

It also has been found that even MS-65 produced by Flex Products, Inc., a mixture of 65% SiO₂/35% MgO, as described in U.S. patent No. 4,702,963, gives exceedingly low WVTR's. This was totally unexpected because published literature has indicated that 1000 x 10⁻¹⁰m (1000 Angstroms) or greater in thickness of oxide coatings are necessary to achieve low WVTRs. Such a barrier film is shown in Figure 5 in which a PET substrate 31 having a surface 32 is coated with a layer 33 of either yttrium oxide or aluminum oxide. A heat seal layer 34 is provided. Alternatively, laminated polypropylene or polyethylene can be used.

It also has been found that low water vapor barrier properties can be achieved on roll coaters at speeds in excess of 0.04 m/s (100' per minute) and still obtain results such as shown in Table 5 below. The roll coated barrier film appears to have a barrier property that is independent of thickness.

**TABLE 5**

| **WVTR'S on ICI-393, 1 mil PET** | |
|---|---|
| **Al**_{**2**}**O**_{**3**} **Thickness** | **WVTR** |
| | g/6.45 x 10⁻²m²/day (g/100 sq.in./day) |
| 75 x 10⁻¹⁰m (75Å) | 0.14 ±0.03 |
| 100 x 10⁻¹⁰m (100Å) | 0.11 ±0.02 |
| 150 x 10⁻¹⁰m (150Å) | 0.10±0.01 |
| 200 x 10⁻¹⁰m (200Å) | 0.12±0.03 |

The foregoing establishes that Al₂O₃, and Y₂O₃ can be utilized as a nucleation layer having a thickness ranging from approximately 50 x 10⁻¹⁰m to 100 x 10⁻¹⁰m (50 to 100 Angstroms) and in combination with siiicon dioxide providing a substantial water vapour transmission reduction of approximately 20 fold. The thin nucleation layers above 50 x 10⁻¹⁰m (50Å) and below 175 x 10⁻¹⁰m (175Å) in thickness in combination with the silicon dioxide layer provides unexpected barrier properties. By way of comparative example, if SnO₂ is used as the nucleation layer, one needs to use an SiO₂ layer on top of it because the SnO₂ by itself does not confer any reduction in water vapor transmission rates (see Table 4). The silicon dioxide overlayer is also beneficial in bonding to the heat seal layer and for providing abrasion resistance to the thin nucleation layer.

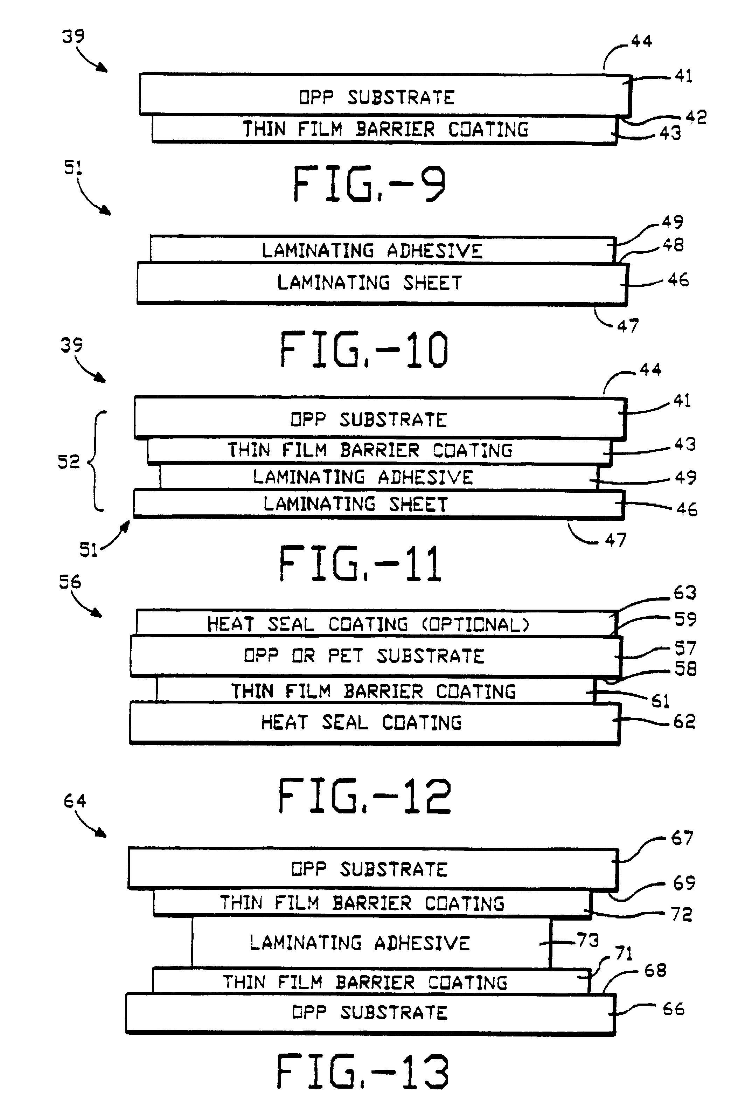

In Figure 9 there is shown a cross-sectional view of a pre-lamination construction 39 to be used in a packaging film. It consists of a substrate 41 formed of a plastic which is capable of tearing in straight lines. A commercially available homo-polymer oriented polypropylene (OPP) film is utilized and has a thickness ranging from 55 gauge to 80 gauge. In the simplest embodiment, the substrate can be formed of a single layer of the homopolymer polypropylene. This is provided with a non-heat sealable characteristic in which only one surface is treated with a corona to provide an ionic discharge which raises the energy level of the surface of the film and permits organic coatings to wet that surface so that printing or graphics can be provided on that surface of the film.

In order to provide tearing along straight lines desired for this packaging film, the homopolymer polypropylene is bi-axially oriented (OPP) so that it has fairly uniform mechanical characteristics in both machine and transverse directions of the film. Other commercially available polypropylene products include a layer of homopolymer polypropylene which has co-extruded thereon a heat seal polymeric layer of a suitable thickness, such as 0.05 x 10⁻⁵ m (.02 mils). A tri-layer design is also commercially available which has a layer of homopolymer polypropylene with both sides having formed thereon co-extruded layers of a heat seal polymeric layer of a suitable thickness, as for example, 0.05 x 10⁻⁵m (.02 mils). In either structure described above, one of the exterior surfaces can be provided with a corona surface treatment of the type hereinbefore described. Additional substrate types that are useful for this application include either polymeric films that have been coated with heat sealable layers on one or both surfaces after extrusion.

The substrate 41 shown in Figure 9 can take the form of any of the various types of polypropylene films hereinbefore described. The barrier layer can be deposited on either side of the polypropylene but the preferred side is the one that has been corona treated. In the embodiments previously described, a nucleation layer has been provided followed by a silicon dioxide layer. In further work, it has been found that most of the barrier properties on PET were provided by the nucleation layer,rather than the SiO₂ layer. For that reason, the thickness of the nucleation layer was increased and the use of the silicon dioxide layer was discontinued. The nucleation layer was typically formed of a thickness ranging from 150 x 10⁻¹⁰m to 275 x 10⁻¹⁰m (150 to 275 Angstroms) depending upon the ultimate barrier properties desired.

Table 6 below shows some WVTR results for roll coated polypropylene with various barrier layers with and without lamination.

**TABLE 6**

| EFFECTS OF LAMINATION² ON BARRIER COATED WEBS | | | |
|---|---|---|---|
| WEB ID | WEB TYPE | BARRIER TYPE | WVTR¹ |
| 1313-3094 | 80ga. OPP | MS65 | 0.087 |
| TM636-5 | 1313-3094/55ga OPP | MS65 | 0.073 |
| TM636-11 | 1313-3094/1313-3094 | MS65 | 0.026 |
| 1313-3092 | 80ga. PET | AL₂O₃ | 0.098 |
| TM636-21 | 1313-3092/92ga. PET | AL₂O₃ | 0.058 |
| TM636-27 | 1313-3092/1313-3092 | AL₂O₃ | 0.030 |

| | | | |
|---|---|---|---|
| ¹WVTR IN g/6.45 x 10⁻²m²/24 hours (GM/100 SQ IN/24 HR) | | | |
| ²LAMINATIONS WERE MADE BY HAND TM636-5 is a lamination of 1313-3094 and 55 ga. OPP. TM636-11 is a lamination of 1313-3094 to itself. TM363-21 is a lamination of 1313-3092 to 92 ga. PET TM363-27 is a lamination of 1313-3092 to itself. | | | |

The above Table 6 shows that by laminating the two barrier coated webs into a composite a synergistic affect is realized. A three fold improvement in water vapor transmission was realized where a two fold improvement would ordinarily be expected.

In order to provide heat sealable capabilities for a packaging film, a laminating sheet 46 formed of a polypropylene can be of the type in which there is provided a co-extruded heat sealable surface on one side and a corona treated surface on the other side with the co-extruded side providing a surface 47 and the corona treated side providing a surface 48. The surface 48 is provided with a suitable laminating adhesive 49 to provide a laminating sheet construction 51. The two constructions 39 and 51 are bonded together in the manner shown in Figure 11 in which the laminating adhesive 49 is brought into contact with a thin barrier coating 43 by the application of heat and pressure so that there is a packaging film 52 which is heat sealable on both sides by use of the surfaces 44 and 47. Typically, the laminating operation is carried out by applying the adhesive as a wet coating and then heating the same, driving out the carrier solvents so that there remains a viscous tacky adhesive. This adhesive is similar to a pressure sensitive adhesive which is adhered to the thin film which, with the application of heat and pressure, causes the laminating adhesive to be activated and to seal to the barrier coating and to bond the two substrates 46 and 41 together so they cannot be peeled apart easily.

Typically, the laminating sheet 46 would have a thickness of 1.3 x 10⁻⁵ m to 1.9 x 10⁻⁵m (1/2 mil to 3/4 mil) whereas the adhesive would have a thickness of approximately 0.25 x 10⁻⁵m (1/10th of a mil). Typically, the substrate 41 can be formed of 70 gauge material whereas the laminating sheet 46 can be formed of 55 gauge material. It is possible to achieve a laminated construction such as that shown in Figure 11 having a thickness of approximately 3.2 x 10⁻⁵m (1.25 mils).

If it is desirable to have a thinner packaging film, an approach such as that shown in Figure 12 can be utilized because at the present time polymeric substrates of thinner material that are heat sealable are not commercially available. The packaging film construction shown in Figure 12 is comprised of a homo-polymer polypropylene or a PET substrate 57 having two surfaces 58 and 59. A barrier coating 61 is applied to the surface 58 in the manner hereinbefore described to a suitable thickness, as for example, 150 x 10⁻¹⁰m (150 Angstroms) utilising aluminum oxide. A heat seal coating 62 is provided on the barrier film 61 to provide a heat seal coating which can be utilized on one side of the packaging film. Depending upon the material utilized for the substrate 57, if needed, a heat seal coating 63 can be provided on the other side 59. Utilizing such a construction it is possible to achieve a packaging film having an overall thickness of less than 2.3 x 10⁻⁵m (0.9 mil) with the 70 gauge substrate 57 having a thickness of 1.8 x 10⁻⁵m (0.70 mil) and with each of the heat seal coatings 62 and 63 having a thickness of 0.25 x 10⁻⁵m (0.1 mil).

In applications where the packaging film is subjected to heat and tension, it is preferable to utilize the construction shown in Figure 11 in which the laminating sheet 46 is provided to accommodate the heating and tensioning which may take place. This ensures that the thin film barrier coating will not be deleteriously affected by the heating and tensioning of a heat seal coating. In the construction shown in Figure 10, the packaging film can be provided without excessive heat or tensioning merely by introducing the two substrates 39 and 51 into a laminating nip after the laminated adhesive has been applied without subjecting the barrier coating 43 to excessive heat during a coating operation when the thin film barrier coating 43 is being applied to the surface 42 of the substrate 41. The only disadvantage is that there is an increased cost for the additional laminating sheet 46 and the additional thickness which may make it necessary to run packaging machinery utilizing the packaging material to run at a lower speed because of the increased heat required for heat sealing because of the thicker packaging material.

In Figure 13 there is shown another construction of a barrier-type packaging film 64 which is comprised of biaxially oriented coextruded polypropylene substrates 66 and 67 having surfaces 68 and 69 respectively upon which there is provided barrier coating 71 and 72 of a suitable thickness ranging from 100 x 10⁻¹⁰m to 300 x 10⁻¹⁰m (100 to 300 Angstroms) formed of a suitable material such as aluminum oxide. The two substrates 66 and 67 are laminated together by applying a laminating adhesive 73 between the facing barrier films 71 and 72 so that the barrier films are face to face in the center of the laminated construction. Such a barrier type packaging film has at least two advantages. By placing the two barrier coatings 71 and 72 facing each other any cracks or holes appearing in one of the barrier coatings would be covered by the other barrier coating to thus, in effect, provide double protection. By providing the biaxially coextruded polypropylene substrates 66 and 67 on opposite sides, the barrier-type packaging film 66 can be heat sealed onto itseif.

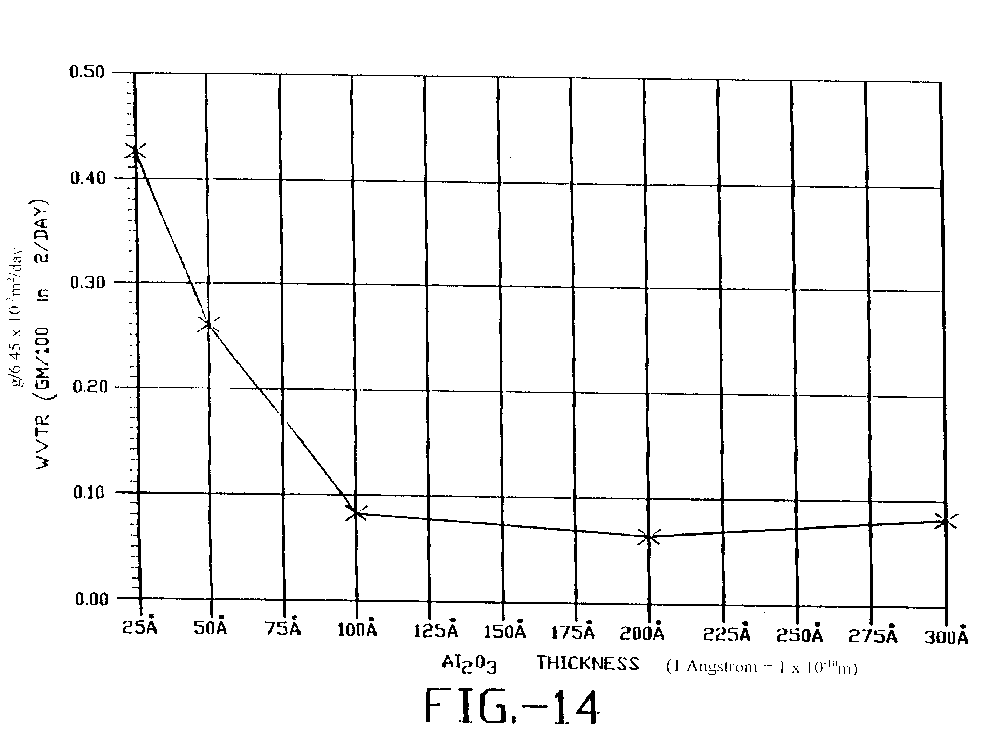

In Figure 14, a graph is shown for the water vapor transmission data for a single layer of aluminum oxide on 70 gauge polypropylene ranging in thickness from 25 x 10⁻¹⁰m to 300 x 10⁻¹⁰m (25 to 300 Angstroms). The graph shows that the water vapour transmission decreases substantially from 25 x 10⁻¹⁰m to 100 x 10⁻¹⁰m (25 Angstroms to 100 Angstroms) and then is approximately the same for increased thicknesses of aluminum oxide (Al₂O₃).

In comparing the graph shown in Figure 14 with the graph snown in Figures 5, 6 and 7, it can be seen that a greater thickness of aluminum oxide is required to achieve the same water vapor transmission rates. The polypropylene requires a greater thickness of barrier coating than does the polyester.

From the foregoing, it can be seen that when a barrier coated substrate is laminated to a heat sealable substrate and when a heat seal coating is applied directly to a barrier film, a packaging film is created which can be used as an overwrap to retard the moisture vapor and gas migration to or from foods, pharmaceutical devices, tobacco products and other industrial products.

As hereinbefore disclosed for polyester based barrier films, a heat seal coating is required to provide a sealing surface. Heat seal coatings may be applied to either/or both sides of the barrier coated film depending on the particular finished product seal or laminating requirements. For lap-type seals, the heat seal coating would normally be applied to both slies of the barrier coated film. For fin-type sealing or lamination, the heat seal coating would normally be applied to the barrier coated side only. For certain special applications, the heat seal coating can be applied to the non-barrier coated side of the film.

For polypropylene films, a heat seal coating may or may not be required for both surfaces of the film depending upon the polypropylene chosen and on the particular application.

For the heat seal layers, conventional heat seal coating resin systems can be utilized which can include polyester urethane, ethylene interpolymers (EVA, EAA type polymers) and acrylic based formulas. Both water reduced and solvent reduced coatings can be used depending upon the type of substrate chosen and the surface treatment of the substrate. In general it has been found that water based heat seal coatings require a corona treated surface to obtain good adhesion of the coating to the substrate. These heat seal coatings can be modified with slip agents to improve their machineability.

From the foregoing it can be seen that there has been provided a barrier film which is highly transparent which serves as a barrier to water vapor and oxygen. Polymeric film substrates can be used. The use of the vacuum deposited inorganic oxide such as the silicon dioxide makes it possible to replace existing aluminized polyester and co-extruded polymeric films. Because of the capabilities of utilizing thinner substrates, the total volume of plastic utilized is greatly reduced. The use of the silicon dioxide or aluminum oxide coating will also reduce the difficulty in recycling plastic because in recycling processes, the thin oxide film will simply act as a trace component and can be worked into the new polymer as a filler. Since the use of a metal layer has been eliminated by the use of inorganic oxides, the barrier film can be utilized for food packaging which can be heated in microwave units. The film of the present invention permits simpler packaging while permitting the customers to view the contents before use and still provide a long shelf life. By utilizing the barrier coating in the present barrier film, the use of PVC and PVDC as barrier materials is eliminated overcoming the possibility of unreacted monomers reaching food contents in the package. The barrier film in the present invention is also advantageous in medical packaging because it permits viewing of the contents of the bag without opening of the same.

The barrier film is also particularly desirable for use in packaging materials where a predetermined moisture content must be maintained in the product. Tobacco is an example of such a product in which it is desired to provide a predetermined moisture content. If excessive moisture is present, the product will mold. If insufficient moisture is present, the product tastes stale. The barrier film of the present invention makes it possible to package tobacco products in a clear film and at the same time to provide a high shelf life in all kinds of climates including those that have high humidity as present in the tropics and those that have low humidities as in desert climates. By utilizing biaxially oriented polypropylene it is possible to provide barrier films which will tear in straight lines making them particularly desirable for use in packaging certain products as, for example, cigarettes.

By providing the barrier film with layers of heat sealing material, the material can be heat sealed onto itself to provide simplified packaging. By providing a heat sealing layer on both sides, the material can be folded either way to heat seal on itself. Also, in certain types of packaging, it is an advantage to provide heat sealing capabilities of both sides on the barrier film.

It should be appreciated that the nucleation layer and barrier layer combinations can be deposited by other methods of vacuum deposition including C.V.D. plasma-type sputtering processes, ion assisted processed such as ion plating, as for example, meta-mode (TM), as well as others well known to those skilled in the art of vacuum deposition.

## Claims

1. A barrier film comprising a flexible plastic substrate ranging from approximately 1.3 x10⁻⁵m to 10.4 x 10⁻⁵ (½ mil to 4 mils) in thickness and having a barrier coating formed on a surface thereof, said barrier coating being formed as a single layer of a single material having a thickness ranging from approximately 50 x 10⁻¹⁰m to 180 x 10⁻¹⁰m (approximately 50 to 180 Angstroms) and being formed of a dielectric material selected from the group of aluminum oxide and yttrium oxide and a mixed oxide alloy consisting of 60% SiO₂ and 35% MgO, said barrier coating in combination with said flexible plastic substrate forming a film having a water white high colourless transparency and providing a barrier to water and oxygen.

2. A barrier film as claimed in claim 1 wherein said barrier coating is formed of aluminium oxide.

3. A barrier film as claimed in claim 1 wherein said plastic substrate is formed essentially of a polyester.

4. A barrier film as claimed in claim 1 wherein said plastic substrate is formed essentially of polypropylene.

5. A barrier film as claimed in claim 1 wherein the material for the barrier coating has a purity of 99% or better.

6. A barrier film as claimed in claim 1 further including a layer of silicon dioxide deposited on the barrier coating and having a thickness ranging from 100 x 10⁻¹⁰m to 1000 x 10⁻¹⁰m (100 to 1000 Angstroms).

7. A barrier film as claimed in claim wherein a heat seal layer is disposed on the barrier coating.

8. A barrier film as claimed in claim 7 wherein the heat seal layer is disposed on the substrate on the side surface opposite to the surface on which the thin film barrier coating is provided.

9. A barrier film as claimed in claim 4 further comprising a laminating sheet formed essentially of polypropylene and an adhesive adhering the laminating sheet to the thin film barrier coating.

10. A barrier film as claimed in claim 9 further comprising an additional substrate formed essentially of polypropylene, a barrier coating deposited on the surface of the additional substrate and an adhesive adhering the barrier coating of the first named substrate to the barrier coating of the additional substrate.

11. A method for forming a barrier film having high colourless water white transparency comprising providing a flexible plastic substrate, evaporating by electron beam evaporation a material selected from a group of aluminum oxide, yttrium oxide or a mixed oxide consisting of 65% SiO₂ and 35% MgO to form a barrier layer directly onto a surface of the substrate and having a thickness of 50 x 10⁻¹⁰m to 180 x 10⁻¹⁰m (50 to 180 Angstroms).

12. A method as claimed in claim 11 further comprising the step of forming a heat seal layer on the barrier layer.

13. A method as claimed in claim 11 further comprising the steps of providing an additional flexible plastic substrate, providing an adhesive on a surface of the additional substrate and laminating the additional substrate to the first named substrate by bringing the laminating adhesive into contact with the barrier layer.

14. A method as claimed in claim 11 further comprising the step of providing a heat seal coating on the barrier layer and on the surface of the substrate opposite to the surface on which the barrier layer is provided.

15. A method as claimed in claim 11 further comprising the steps of providing the first named flexible plastic substrate so that it consists essentially of polypropylene, providing an additional flexible plastic substrate formed essentially of polypropylene, providing a barrier layer on the first named substrate and utilising an adhesive between the barrier layer on the first named and the additional substrate.

16. A method as claimed in claim 11 further comprising the step of evaporating onto the barrier layer a layer of silicon dioxide having a thickness ranging from 100 x 10⁻¹⁰m to 1000 x 10⁻¹⁰m (100 to 1000 Angstroms).

17. A method as claimed in claim 11 wherein the barrier and silicon dioxide layers are evaporated onto the substrate while the substrate is moving.

## Patentansprüche

1. Sperrfilm mit einem flexiblen Kunststoffsubstrat, das eine Dicke im Bereich von 1,3 x 10⁻⁵m bis 10,4 x 10⁻⁵m (1/2 Tausendstel Zoll bis 4 Tausendstel Zoll) hat und eine Sperrbeschichtung aufweist, die auf einer Oberfläche von ihm ausgebildet ist, wobei die Sperrbeschichtung als eine Einzelschicht aus einem einzigen Material ausgebildet ist, eine Dicke im Bereich von etwa 50 x 10⁻¹⁰m bis 180 x 10⁻¹⁰m (etwa 50 bis 180 Angström) hat und von einem dielektrischen Material gebildet wird, das aus der Gruppe von Aluminiumoxid und Yttriumoxid und einer Oxidmischlegierung auswählt wird, die aus 65% SiO₂ und 35% MgO besteht, und wobei die Sperrbeschichtung in Kombination mit dem flexiblen Kunststoffsubstrat einen Film bildet, der eine wasserklare hohe farblose Transparenz aufweist und eine Sperre für Wasser und Sauerstoff bildet.

2. Sperrfilm nach Anspruch 1, bei welchem die Sperrbeschichtung aus Aluminiumoxid gebildet wird.

3. Sperrfilm nach Anspruch 1, bei welchem das Kunststoffsubstrat im wesentlichen von einem Polyester gebildet wird.

4. Sperrfilm nach Anspruch 1, bei welchem das Kunststoffsubstrat im wesentlichen von Polypropylen gebildet wird.

5. Sperrfilm nach Anspruch 1, bei welchem das Material für die Sperrbeschichtung eine Reinheit von 99% oder besser aufweist.

6. Sperrfilm nach Anspruch 1, welcher weiterhin eine Schicht aus Siliziumdioxid einschließt, die auf der Sperrbeschichtung abgeschieden ist und eine Dicke im Bereich von 100 x 10⁻¹⁰m bis 1000 x 10⁻¹⁰m (100 bis 1000 Angström) hat.

7. Sperrfilm nach Anspruch 1, bei welchem auf der Sperrbeschichtung eine Heißsiegelschicht angeordnet ist.

8. Sperrfilm nach Anspruch 7, bei welchem die Heißsiegelschicht auf dem Substrat auf der Seitenfläche angeordnet ist, die der Oberfläche gegenüberliegt, auf der die Dünnfilmsperrbeschichtung vorgesehen ist.

9. Sperrfilm nach Anspruch 4, welcher weiterhin eine Laminierfolie aufweist, die im wesentlichen von Polypropylen und einem Klebstoff gebildet wird, der die Laminierfolie mit der Dünnfilmsperrbeschichtung haftend verbindet.

10. Sperrfilm nach Anspruch 9, welcher weiterhin ein zusätzliches Substrat, das im wesentlichen von Polypropylen gebildet wird, eine Sperrbeschichtung, die auf der Oberfläche des zusätzlichen Substrats abgeschieden ist, und einen Klebstoff aufweist, der die Sperrbeschichtung des erstgenannten Substrats mit der Sperrbeschichtung des zusätzlichen Substrats haftend verbindet.

11. Verfahren zur Herstellung eines Sperrfilms, der eine hohe farblose wasserklare Transparenz aufweist, bei welchem ein flexibles Kunststoffsubstrat bereitgestellt wird und durch Elektronenstrahlverdampfung ein Material, das aus einer Gruppe aus Aluminiumoxid, Yttriumoxid oder einem Mischoxid bestehend aus 65% SiO₂ und 35% MgO ausgewählt wird, direkt auf die Oberfläche des Substrats zur Bildung einer Sperrschicht aufgedampft wird, die eine Dicke von 50 x 10⁻¹⁰m bis 180 x 10⁻¹⁰m (50 bis 180 Angström) hat.

12. Verfahren nach Anspruch 11, welches weiterhin den Schritt aufweist, eine Heißsiegelschicht auf der Sperrschicht auszubilden.

13. Verfahren nach Anspruch 11, welches weiterhin die Schritte aufweist, ein zusätzliches flexibles Kunststoffsubstrat bereitzustellen, einen Klebstoff auf einer Oberfläche des zusätzlichen Substrats vorzusehen und das zusätzliche Substrat auf das zuerst genannte Substrat zu laminieren, indem der Laminierklebstoff in Kontakt mit der Sperrschicht gebracht wird.

14. Verfahren nach Anspruch 11, welches weiterhin den Schritt aufweist, eine Heißsiegelbeschichtung auf der Sperrschicht und auf der Oberfläche des Substrats vorzusehen, die der Oberfläche gegenüberliegt, auf der die Sperrschicht vorgesehen ist.

15. Verfahren nach Anspruch 11, welches weiterhin die Schritte aufweist, das zuerst genannte flexible Kunststoffsubstrat so vorzusehen, daß es im wesentlichen aus Polypropylen besteht, ein zusätzliches flexibles Kunststoffsubstrat bereitzustellen, das im wesentlichen aus Polypropylen gebildet wird, eine Sperrschicht auf dem zuerst genannten Substrat vorzusehen und zwischen der Sperrschicht und dem zuerst genannten und dem zusätzlichen Substrat einen Klebstoff zu verwenden.

16. Verfahren nach Anspruch 11, welches weiterhin den Schritt aufweist, auf die Sperrschicht eine Schicht aus Siliziumdioxid aufzudampfen, die eine Dicke im Bereich von 100 x 10⁻¹⁰m bis 1000 x 10⁻¹⁰m (100 bis 1000 Angström) hat.

17. Verfahren nach Anspruch 11, bei welchem die Sperrschicht und die Siliziumdioxidschicht auf das Substrat aufgedampft werden, während sich das Substrat bewegt.

## Revendications

1. Film de barrière comprenant un substrat en matière plastique flexible d'une épaisseur de l'ordre d'environ 1,3 x 10⁻⁵ m à 10,4 x 10⁻⁵ m (1/2 mil à 4 mils) et présentant un revêtement de barrière formé sur une de ses surfaces, le revêtement de barrière étant formé d'une couche unique d'une matière unique présentant une épaisseur de l'ordre d'environ 50 x 10⁻¹⁰ m à 180 x 10⁻¹⁰ m (environ 50 à 180 Angströms) et étant formé d'une matière diélectrique choisie parmi le groupe comprenant de l'oxyde d'aluminium et de l'oxyde d'yttrium et un alliage d'oxydes mixtes consistant en 60 % de SiO₂ et 35 % de MgO, le revêtement de barrière formant, en combinaison avec le substrat en matière plastique flexible, un film ayant une haute transparence incolore, limpide comme de l'eau, et procurant une barrière à l'eau et à l'oxygène.

2. Film de barrière suivant la revendication 1, caractérisé en ce que le revêtement de barrière est formé d'oxyde d'aluminium.

3. Film de barrière suivant la revendication 1, caractérisé en ce que le substrat en matière plastique est formé essentiellement d'un polyester.

4. Film de barrière suivant la revendication 1, caractérisé en ce que le substrat en matière plastique est formé essentiellement de polypropylène.

5. Film de barrière suivant la revendication 1, caractérisé en ce que la matière pour le revêtement de barrière présente une pureté de 99 % ou davantage.

6. Film de barrière suivant la revendication 1, comprenant en outre une couche de dioxyde de silicium déposée sur le revêtement de barrière et présentant une épaisseur de l'ordre de 100 x 10⁻¹⁰ m à 1000 x 10⁻¹⁰ m (100 à 1000 Angströms).

7. Film de barrière suivant la revendication 1, caractérisé en ce qu'une couche de thermoscellage est déposée sur le revêtement de barrière.

8. Film de barrière suivant la revendication 7, caractérisé en ce que la couche de thermoscellage est déposée sur le substrat sur la surface du côté opposé à la surface sur laquelle le mince film de revêtement de barrière est prévu.

9. Film de barrière suivant la revendication 4, caractérisé en ce qu'il comprend en outre une feuille de stratification formée essentiellement de polypropylène et d'un adhésif faisant adhérer la feuille de stratification au mince film de revêtement de barrière.

10. Film de barrière suivant la revendication 9, caractérisé en ce qu'il comprend en outre un substrat supplémentaire formé essentiellement de polypropylène, un revêtement de barrière déposé sur la surface du substrat supplémentaire et un adhésif faisant adhérer le revêtement de barrière du premier substrat cité au revêtement de barrière du substrat supplémentaire.

11. Procédé de formation d'un film de barrière présentant une transparence hautement incolore, limpide comme de l'eau, comprenant la prévision d'un substrat en matière plastique flexible, une évaporation par un faisceau électronique d'une matière choisie parmi un groupe comprenant de l'oxyde d'aluminium, de l'oxyde d'yttrium ou un oxyde mixte consistant en 65 % de SiO₂ et 35 % de MgO, pour former une couche de barrière directement sur une surface du substrat, couche qui présente une épaisseur de 50 x 10⁻¹⁰ m à 180 x 10⁻¹⁰ m (50 à 180 Angströms).

12. Procédé suivant la revendication 11, caractérisé en ce qu'il comprend en outre l'étape de formation d'une couche de thermoscellage sur la couche de barrière.

13. Procédé suivant la revendication 11, caractérisé en ce qu'il comprend en outre les étapes de prévision d'un substrat en matière plastique flexible supplémentaire, de prévision d'un adhésif sur une surface du substrat supplémentaire et de stratification du substrat supplémentaire sur le premier substrat cité en mettant l'adhésif de stratification en contact avec la couche de barrière.

14. Procédé suivant la revendication 11, caractérisé en ce qu'il comprend en outre l'étape de prévision d'un revêtement de thermoscellage sur la couche de barrière et sur la surface du substrat qui est à l'opposé de la surface sur laquelle la couche de barrière est prévue.

15. Procédé suivant la revendication 11, caractérisé en ce qu'il comprend en outre les étapes de prévision du premier substrat cité en matière plastique flexible de façon qu'il consiste essentiellement en polypropylène, de prévision d'un substrat en matière plastique flexible supplémentaire formé essentiellement de polypropylène, de prévision d'une couche de barrière sur le premier substrat cité et d'utilisation d'un adhésif entre la couche de barrière du premier substrat cité et le substrat supplémentaire.

16. Procédé suivant la revendication 11, caractérisé en ce qu'il comprend en outre l'étape d'évaporation sur la couche de barrière d'une couche de dioxyde de silicium ayant une épaisseur de l'ordre de 100 x 10⁻¹⁰ m à 1000 x 10⁻¹⁰ m (100 à 1000 Angströms).

17. Procédé suivant la revendication 11, caractérisé en ce que les couches de barrière et de dioxyde de silicium sont évaporées sur le substrat pendant que le substrat est en déplacement.
